# EUROPEAN PATENT SPECIFICATION

(11) **EP 0 729 484 B1**
(45) Date of publication and mention of the grant of the patent: **01.03.2000**
(21) Application number: 94931806.7
(22) Date of filing: 12.10.1994
(51) Int. Cl.: C08G 59/18, C08G 59/50, C08J 5/24

(54) **CURE INHIBITED EPOXY RESIN COMPOSITIONS AND LAMINATES PREPARED FROM THE COMPOSITIONS**
HÄRTUNGSINHIBIERTE EPOXIDHARZZUSAMMENSETZUNGEN UND DARAUS HERGESTELLTE LAMINATE
COMPOSITIONS DE RESINE EPOXY INHIBEES AVEC INTERRUPTION DU DURCISSEMENT ET STRATIFIES PREPARES A PARTIR DE CES DERNIERES

(30) Priority: 02.11.1993 US 146652
(43) Date of publication of application: 04.09.1996
(73) Proprietor: THE DOW CHEMICAL COMPANY, Midland, Michigan 48674 (US)
(72) Inventor: SCHULTZ, Craig, E., Lake Jackson, Texas 77566 (US); BERTRAM, James, L., Lake Jackson, TX 77566 (US); CLAY, William, A., Angleton, TX 77515 (US); XIA, Guang-Ming, Lake Jackson, TX 77566 (US); GAN, Joseph, F-67100 Strasbourg (FR)
(74) Representative: Casalonga, Axel
(86) International application number: US9411452
(87) International publication number: WO9512627

(56) References cited:
- EP-A- 0 117 113
- EP-A- 0 557 068
- US-A- 4 707 518

## Description

This invention relates to epoxy resin compositions, and particularly to compositions useful for making electrical laminates.

Epoxy resin compositions are commonly used to make electrical laminates according to the following process steps:
(1) a substrate is impregnated with an epoxy resin composition containing the resin, a curing agent for the resin and a catalyst for the curing reaction. The concentration of catalyst is usually about 0.1 parts catalyst per 100 parts epoxy resin (by weight). Generally the composition contains one or more organic solvents in which the various components are dissolved or dispersed, with a solid content of between 45 and 90 percent. The substrate is usually a cloth of woven or unwoven fibers, and particularly glass fibers. The composition is usually applied by immersing the substrate in a bath of the composition, but it may be applied by other methods, such as spraying or rolling.
(2) The impregnated substrate is passed through a heated zone to remove the solvent by evaporation, and optionally to partially-cure the resin composition. The process of partially-curing the resin is called "B-staging." The partially-cured product is called a prepreg.
(3) If the prepreg is not intended for immediate use, it is cooled and stored at a temperature less than 50°C.
(4) One or more prepregs are stacked with one or more sheets of electrical conductor and pressed at elevated temperature to cure the composition and form a laminate. In this curing process the resin coating on the glass cloth flows and mixes with the coating on adjacent glass clothes thereby resulting in a fusing of the glass cloth layers together, via the cured epoxy resin. The conductor is usually a sheet of copper, although gold or other conductors may also be used.
(5) Optionally, the cured laminate is post-treated by exposing it to high temperature.

Frequently, the epoxy resin composition is formulated by one manufacturer, the prepreg is made by a second, and the laminate is made by a third. Therefore, the formulated composition must be shelf-stable until it is used to make prepreg, and the prepreg must stop curing when it is cooled and remain shelf-stable until it is used by the laminator. Many common formulations are not sufficiently stable. If stabilizers are added, they often slow the curing of the resin.

It is known to use boric acid as an inhibitor for the reaction. See, for example, Bertram et al., EPO Application 91304277.6, published as EPO Publication 0458502 on November 27, 1991. Compositions that contain boric acid cure rapidly at curing temperatures, but have good shelf-stability both as formulations and in prepregs. It would be desirable to identify other inhibited compositions that will provide similar good results.

One aspect of the present invention is an epoxy resin composition comprising:
a) a polyepoxide;
b) an amine or amide curing agent for the polyepoxide; and
c) a catalyst for the reaction of the polyepoxide with the curing agent,
d) a cure inhibitor
   characterized in that:
   (1) the catalyst is an imidazole compound having a concentration of 0.3 to 1 part per 100 parts polyepoxide by weight phr and
   (2) the cure inhibitor is a halide, oxide, hydroxide or alkoxide of zinc, tin, titanium, cobalt, manganese, iron, silicon or aluminum or a boron oxide or alkoxide.

A second aspect of the present invention is a process for making a prepreg comprising the steps of:
(1) impregnating a substrate with a curable composition as previously described;
(2) drawing off solvent from the composition and partially curing the composition at a temperature of 80°C to 190°C to form a B-staged prepreg; and
(3) cooling the B-staged prepreg and storing it at a temperature less than 50°C.

A third aspect of the present invention is a prepreg comprising:
(1) a fiber-containing substrate; and
(2) a partially-cured curable composition as previously described impregnated upon the substrate.

Another aspect of the invention is the use of a prepreg composition as described hereinbefore and in particular its use which further comprises the step of pressing one or more B-staged prepregs with one or more sheets of an electrically conductive material to form a laminate and curing the curable composition in the laminate.

The invention has several advantages. The composition can be exposed to temperatures at which any solvent present is removed by evaporation without significant curing of the epoxy resin. Preferably this composition is stable for more than two days, more preferably stable for more than two months, and most preferably stable for six months or more, at ambient temperatures. The B-staged compositions are also stable for similar periods at about room temperature. However, the compositions also contain a high concentration of catalyst, so that they cure quickly at laminating temperatures. Additionally, the compositions frequently cure to provide a laminate with a higher glass-transition temperature than equivalent compositions made without the high catalyst concentration and inhibitor.

Polyepoxides used in the present invention are compounds or mixtures of compounds containing on average more than one epoxy moiety. Polyepoxide as used herein includes partially advanced epoxy resins that is, the reaction product of a polyepoxide and a curing agent, wherein the reaction product has an average of at least one unreacted epoxide unit per molecule. The polyepoxide preferably contains 2 to 12 epoxy groups per molecule.

For example, the polyepoxide may be a poly(glycidyl ether) of a polyhydric phenol, that is, compounds having an average of more than one aromatic hydroxyl group per molecule such as, for example, dihydroxy phenols, biphenols, bisphenols, halogenated biphenols, halogenated bisphenols, alkylated biphenols, alkylated bisphenols, hydrogenated bisphenols, trisphenols, phenol-aldehyde novolac resins, halogenated and/or substituted phenol-aldehyde novolac resins, phenol-hydrocarbon resins and halogenated or alkylated variations of those resins, or any combination thereof. Polyglycidyl ethers of the following polyhydric phenols are more preferred: bisphenols; halogenated bisphenols; hydrogenated bisphenols; novolac resins; and polyalkylene glycols.

The preparation of such compounds is well known in the art. See Kirk-Othmer, Encyclopedia of Chemical Technology, 3rd Ed., Vol. 9, pp. 267-289. Examples of preferred epoxy resins and their precursors are described in Davis et al., U.S. Patent 4,251,594 (February 17, 1981); Berman et al., U.S. Patent 4,604,317 (August 5, 1986); Wang, U.S. Patent 4,672,103 (June 9, 1987); Bogan, U.S. Patent 4,710,429 (December 1, 1987); Walker et al., U.S. Patent 5,066,735 (November 19, 1991) (individually and in the claimed mixtures); Koenig et al., U.S. Patent 5,112,932 (May 12, 1992); and Bertram et al., U.S. Patent 5,169,473 (December 8, 1992).

Highly preferable epoxy resins include, for example, the diglycidyl ethers of resorcinol, catechol, hydroquinone, biphenol, bisphenol A, bisphenol AP (1,1-bis(4-hydroxylphenyl)-1-phenyl ethane), bisphenol F, bisphenol K, tetrabromobisphenol A, phenolformaldehyde novolac resins, alkyl substituted phenol-formaldehyde resins, phenolhydroxybenzaldehyde resins, cresol-hydroxybenzaldehyde resins, dicyclopentadiene-phenol resins, dicyclopentadiene-substituted phenol resins, tetramethylbiphenol, tetramethyltetrabromobiphenol, tetramethyltribromobiphenol, tetrachlorobisphenol A, or any combination thereof.

Other preferable polyepoxides are the glycidyl ethers of compounds having an average of more than one aliphatic hydroxyl group per molecule such as, for example, aliphatic diols, polyether diols, polyether triols, polyether tetrols and any combination thereof. Also suitable are the alkylene oxide adducts of compounds containing an average of more than one aromatic hydroxyl group per molecule such as, for example, the ethylene oxide, propylene oxide, or butylene oxide adducts of dihydroxy phenols, biphenols, bisphenols, halogenated bisphenols, alkylated bisphenols, trisphenols, phenol-aldehyde novolac resins, halogenated phenol-aldehyde novolac resins, alkylated phenol-aldehyde novolac resins, hydrocarbonphenol resins, hydrocarbon-halogenated phenol resins, or hydrocarbon-alkylated phenol resins, or any combination thereof.

In one embodiment polyepoxide refers to an advanced epoxy resin which is the reaction product of one or more polyepoxides, as described previously, with one or more polyhydroxy hydrocarbons or a halogenated derivative thereof. Such polyhydroxy hydrocarbons have been described previously. Alternatively, a polyepoxide can be reacted with a carboxyl-substituted hydrocarbon. A carboxyl substituted hydrocarbon is a compound with a hydrocarbon backbone and one or more carboxyl moieties, preferably more than one, and most preferably two. Preferably such compounds correspond to Formula (I);

R⁵(COOH)ᵤ (I)

wherein R⁵ is a C₁₋₄₀ hydrocarbyl moiety (optionally containing oxygen along the backbone), and u is an integer of one or greater. R⁵ is preferably a C₁₋₄₀ straight- or branched-chain alkane or alkene, optionally containing oxygen. Preferably u is 1 to 4, and most preferably 2. Fatty acids and fatty acid dimers are among the useful carboxylic acid substituted hydrocarbons. Included in the fatty acids are caproic acid, caprylic acid, capric acid, versatic® acid, lauric acid, myristic acid, palmitic acid, stearic acid, palmitoleic acid, oleic acid, linoleic acid, linolenic acid, erucic acid, pentadecanoic acid, margaric acid, arachidic acid, and dimers thereof.

In another embodiment, the polyepoxide is the reaction product of a polyepoxide and a compound containing more than one isocyanate moiety, a polyisocyanate. Preferably the polyepoxide is an epoxy-terminated polyoxazolidone. It preferably has from 5 to 30, more preferably 5 to 20, most preferably 10 to 20 weight percent isocyanate content and has from 50 to 100 percent of the original isocyanate groups convened to oxazolidone rings and from 0 to 50 percent of the original isocyanate groups convened to isocyanurate rings whenever prepared according to the process described herein. Epoxy-terminated polyoxazolidone (isocyanate modified epoxy resin) is preferably prepared by the process described in Koenig, U.S. Patent 5,112,932 (May 12, 1992).

Amine- and amide-containing curing agents in the present invention are compounds that contain on average more than one active hydrogen atom, wherein the active hydrogen atoms are bonded to the same nitrogen atom or to different nitrogen atoms. Examples of suitable curing agents include: compounds that contain a primary amine or amide moiety and compounds that contain two or more primary or secondary amine or amide moieties linked to a common central organic moiety. Examples of suitable amine-containing curing agents include: diethylene triamine, triethylene tetramine, dicyandiamide, melamine, pyridine, cyclohexylamine, benzyldimethylamine, benzylamine, diethylaniline, triethanolamine, piperidine, N,N-diethyl-1,3-propane diamine,and soluble adducts of amines and polyepoxides and their salts, such as described in U.S. Patents 2,651,589 and 2,640,037.

Polyamides are preferably the reaction product of a polyacid and an amine. Examples of polyacids used in making these polyamides include, among others, 1,10-decanedioic acid, 1,12-dodecanodienedioic acid, 1,20-eicosadienedioic acid, 1,14-tetradecanedioic acid, 1,18-octadecanodioic acid and dimerized and trimerized fatty acids. Amines used in making the polyamides include preferably the aliphatic and cycloaliphatic polyaminos as ethylene diamine, diethylene triamine, triethylene tetramine, tetraethylene pentamine, 1,4-diamino-butane, 1,3-diaminobutane, hexamethylene diamine and 3-(N--isopropylamino)propylamine. Especially preferred polyamides are those derived from the aliphatic polyamides containing no more than 12 carbon atoms and polymeric fatty acids obtained by dimerizing and/or trimerizing ethylenically unsaturated fatty acids containing up to 25 carbon atoms. Those preferred polyamides preferably have a viscosity between 10 and 750 poises at 40°C, and more preferably 20 to 250 poises at 40°C. Preferred polyamides also have amine values of 50 to 450.

Preferred curing agents are aliphatic polyamines, polyglycoldiamines, polyoxypropylene diamines, polyoxypropylenetriamines, amidoamines, imidazolines, reactive polyamides, ketimines, araliphatic polyamines (that is,xylylenediamine), cycloaliphatic amines (that is,isophoronediamine or diaminocyclohexane), menthane diamine, 3,3-dimethyl-4,4-diamino-dicyclohexylmethane, heterocyclic amines (aminoethyl piperazine), aromatic polyamines, (methylene dianiline), diamino diphenyl sulfone, mannich base, phenalkamine and N,N',N''-tris(6-aminohexyl) melamine. The most preferred curing agents are cyanamide, dicyandiamide, and its derivatives, diaminodiphenyl sulfone and methylene dianiline.

The ratio of curing agent to epoxy resin is preferably suitable to provide a fully cured resin. The amount of curing agent which may be present may vary depending upon the particular curing agent used. The curable composition preferably contains from 0 to 150 parts of curing agent per hundred parts of resin (phr), more preferably from 0.5 to 30 phr curing agent, more highly preferably from 1.0 to 10.0 phr curing agent, and most preferably from 2 to 4 phr curing agent. The equivalent ratio of epoxy moieties to curing moieties is preferably at least 0.8:1 and more preferably at least 0.9:1. The equivalent ratio is preferably no more than 1.5:1 and more preferably no more than 1.2:1.

Catalysts useful in this invention are those catalysts which catalyze the reaction of a polyepoxide with a curing agent and which remain latent in the presence of the inhibitor at lower temperatures. Examples of imidazole compounds useful as curing catalysts in the present invention are described in Walker et al., U.S. Patent 4,868,059 (September 19, 1989) and Bertram et al., U.S. Patent 5,169,473 (December 8, 1992).

The catalyst is an imidazole compound, such as imidazoles, benzimadazoles, imidazolidines, imidazolines, substituted variations thereof and combinations thereof. Especially preferred are the alkyl-substituted imidazoles; 2,5-dichloro-4-ethyl imidazole; and phenyl substituted imidazoles, and mixtures thereof. Even more preferred are 2-methyl imidazole; 2-ethyl-4-methyl imidazole; 1,2-dimethylimidazole; and 2-phenyl imidazole. Most preferred is 2-methyl imidazole.

The catalyst should be present in quantities of at least 15 meq of catalyst for each equivalent of epoxy resin. The concentration of catalyst is preferably at least about 20 meq per equivalent of epoxy resin. It is preferably no more than about 50 meq per equivalent of epoxy resin and more preferably no more than about 25 meq per equivalent of epoxy resin. The higher than normal catalyst loadings make it possible to have very rapid cure at higher temperatures. When the catalyst is 2-methylimidazole, the concentration is preferably at least about 0.3 phr (parts catalyst per 100 parts resin, by weight) and more preferably at least about 0.4 phr. The concentration is preferably no more than about 1 phr, and more preferably no more than about 0.5 phr.

The composition contains a Lewis acid curing inhibitor, which forms a complex with the catalyst. The complexes exist in equilibrium with the uncomplexed catalyst and complexing agent. At any given moment a portion of the catalyst is complexed with the complexing agent and a portion is not. The portion of free catalyst is dependent upon several variables, including the complexing agent its concentration relative to the catalyst, the temperature of the mixture and the solvent used.

The inhibitor and its concentration are selected such that the resin does not gel too fast at temperatures that are ordinarily used to impregnate and laminate a composite. (Stroke-cure gel time of a resin can be determined by test DOWM101210-TE92A, which is described in the working examples). The stroke-cure gel time of the resin containing the inhibitor at about 171°C is preferably at least about 50 percent longer than the gel time of a similar composition containing no inhibitor. The stroke-cure gel time is preferably at least about 100 percent longer, and more preferably at least about 200 percent longer. At about 171°C, the stroke-cure gel time of the composition is preferably more than 70 seconds, highly preferably more than 100 seconds, more preferably more than 200 seconds, more highly preferably more than 250 seconds, and most preferably more than 300 seconds. It is desirable to keep the gel time as long as possible, but it is seldom more than about 1000 seconds for useful compositions. The composition preferably exhibits no significant change in its gel time when stored at 20°C to 25°C or less over a period of at least 2 days, more preferably at least about 10 days and most preferably at least about 30 days.

The inhibitor should also dissociate from the catalyst at curing temperatures, so that the excess catalyst causes more rapid curing than compositions with an ordinary catalyst content and no inhibitor. A sample is considered cured when its glass-transition temperature changes by no more than 3°C between first and second testing by IPC test method: 2.4.25 (revision B dated 12/87) as described in the testing methods section hereinafter. (This test may not meet every user's definition of a "fully cured" resin, since different users may have different performance criteria that a cured resin must meet. Some users may require further curing to meet all performance criteria. However, the test does establish that under curing conditions there is at least as much catalyst activity as - and preferably more catalyst activity than - a system with ordinary catalyst loadings and no inhibitor). The composition should be cured in no more than about 60 minutes at temperatures of about 175°C. The composition is highly preferably cured in no more than about 50 minutes, preferably in no more than about 45 minutes, more preferably in no more than about 30 minutes, and most preferably in no more than about 20 minutes.

Examples of suitable inhibitors include halides, oxides, hydroxides and alkoxides of zinc, tin, titanium, cobalt, manganese, iron, silicon, boron, aluminum and similar compounds (other than boron halides or boric acid) - for instance boroxines (such as trimethoxyboroxine), boron oxide, alkyl borates, zinc halides (such as zinc chloride) and other Lewis acids that tend to have a relatively weak conjugate base. When the formulation is intended for use in electrical laminates, then the inhibitor preferably contains no significant levels of halide. Boric acid as used herein includes metaboric acid and boric anhydride.

The molar ratio of catalyst to inhibitor is selected to provide the results previously described. The optimum ratio may vary from catalyst to catalyst and from inhibitor to inhibitor. In most cases, the molar ratio of inhibitor to catalyst is preferably at least 0.6:1, more preferably at least 0.75:1 and most preferably at least 1:1. The molar ratio of inhibitor to catalyst is preferably no more than 3:1, more preferably no more than 1.4:1 and most preferably no more than 1.35:1.

The inhibitor and catalysts may be separately added to the compositions of this invention, or may be added as a complex. The complex is formed by contacting and intimately mixing a solution of the inhibitor with a solution of the catalyst. Optionally, an acid having a weak nucleophilic anion may be present. Such contacting generally is performed at ambient temperature, although other temperatures may be used, for example, temperatures of from 0°C to 100°C, more preferably from 20°C to 60°C. The time of contacting is that sufficient to complete formation of the complex, and depends on the temperature used, with from 1 to 120 minutes preferred, and 10 to 50 minutes more preferred. Preferred solvent for the catalyst and the inhibitor are polar solvents, with alcohols being preferred. Lower alcohols are even more preferred, with methanol most preferred.

The catalysts can be employed alone or in combination with other catalysts, preferably catalytic products resulting from reacting the onium or amine compounds or a combination thereof with an inorganic acid containing a weak nucleophile. By the term "weak nucleophile" or "weak nucleophilic," it is meant that the material has a nucleophilicity value "n" of greater than zero and less than 2.5 as described by C. G. Swain and C. B. Scott in J. Am. Chem. Society, Vol. 75, p. 141 (1953). Particularly suitable inorganic acids having a weak nucleophilic anion or weak nucleophile include, for example, fluoboric acid, fluoarsenic acid, fluoantimonic acid, fluophosphoric acid, chloroboric acid, chloroarsenic acid, chloroantimonic acid, chlorophosphoric acid, perchloric acid, chloric acid, bromic acid, iodic acid and any combination thereof. Most particularly the acid is fluoboric acid.

The composition of the present invention may optionally be a powder without solvent, but is preferably in a solution or dispersion with a solvent. Preferably the concentration of solids in the solvent is at least about 50 percent and no more than about 75 percent. The solvent is preferably an organic solvent, such as ketones, alcohols, glycol ethers, aromatic hydrocarbons and mixtures thereof. Preferred examples of solvents include methylethyl ketone, methylisobutylketone, propylene glycol methylether, ethylene glycol methylether, methyl amyl ketone, methanol, isopropanol, toluene, xylene and dimethylformamide. Examples of suitable solvents are described in Berman et al., U.S. Patent 4,756,954 (July 12, 1988). A single solvent may be used, but in many applications a separate solvent is used for each component. It is preferable that the various solvents used be miscible with one another. Preferred solvents for the epoxy resins are ketones, including acetone and methylethylketone. Preferred solvents for the curing agents are slightly polar solvents, amides, for example, DMF, ether alcohols such as methyl, ethyl, propyl or butyl ethers of ethylene glycol, diethylene glycol, propylene glycol or dipropylene glycol, for example, ethylene glycol monomethyl ether, or 1-methoxy-2-propanol. The catalysts and inhibitors are preferably dissolved in polar solvents, in particular alcohols, preferably lower alkanols and most preferably methanol.

The compositions of the present invention may be used to make electrical laminates, as previously described. Examples of appropriate substrates include fiber-containing materials such as cloth, mesh, web or fibers. Preferably, such materials are made from glass, fiberglass, paper, plastics such as aromatic polyamides and graphite. Preferred materials include glass or fiberglass, in cloth or web form. Other additives may also be present including fillers, dyes, pigments, surfactants and flow control agents.

B-staging may be carried out in a single temperature stage, or in multiple temperature stages. Optionally, the coated reinforcing materials are passed through a heated zone at a temperature sufficient to cause the solvents to evaporate, but below the temperature at which the polyepoxide undergoes significant cure during the residence time in the heated zone. The residence time of the coated reinforcing material in the heated zone is preferably from 0.5 to 15 minutes, more preferably from 1 to 10 minutes, and most preferably from 1.5 to 5 minutes. Preferable temperatures of such zone are from 80°C to 230°C, more preferably from 100°C to 200°C, and most preferably from 140°C to 190°C. Preferably there is a means in the heated zone to remove the solvent, either by passing an inert gas through the oven, or drawing a slight vacuum on the oven. In many embodiments the coated materials are exposed to zones of increasing temperature. The first zones are designed to cause the solvent to volatilize so it can be removed. The latter zones are designed to result in partial cure of the polyepoxide.

The inhibited catalysts of the present invention are latent at low temperatures, meaning that the curable resin will substantially stop curing after it is B-staged if the curable resin is cooled down, preferably to below 50°C and more preferably to about room temperature (20°C to 25°C). The minimum temperature is not critical, but prepregs are preferably stored at at least -10°C and more preferably at least 10°C. The B-staged resin is then storage stable, preferably for at least about 10 days, more preferably for at least about 20 days, and most preferably for at least about 30 days. This makes it possible to interrupt curing of prepregs after B-staging, to ship or store the B-staged prepregs until they are needed, and to cure them to make laminates at a later time.

One or more sheets of prepreg are preferably processed into laminates with one or more sheets of electrically-conductive material such as copper. Before being cured the parts may be cut and stacked or folded and stacked into a part of desired shape and thickness. The pressures are preferably from 1 to 200 kg/cm², and more preferably from 10 to 100 kg/cm². The temperature is preferably between 100°C and 190°C, more preferably between 120°C and 180°C, and most preferably between 140°C and 175°C. The residence times are preferably from 10 minutes to 120 minutes, more preferably from 20 to 90 minutes, and most preferably from 30 to 50 minutes.

One embodiment of such a process is known as a continuous process. In such a process, the reinforcing material is taken from the oven and appropriately arranged into the desired shape and thickness and pressed at very high temperatures for short times. Such high temperatures are from 180°C to 250°C, more preferably 190°C to 210°C, at times of 1 to 10 minutes and from 2 to 5 minutes. Such high speed pressing allows for the more efficient utilization of processing equipment. In such embodiments the preferred reinforcing material is a glass web or woven cloth.

The post-cure is usually performed at from 130°C to 200°C for from 20 to 200 minutes. This post cure step may be performed in a vacuum to remove any components which may volatilize.

The ultimate coated reinforced parts prepared from the composition of this invention often demonstrate a higher Tg than where the compositions not within the scope of this invention are used. In some embodiments the Tg is at least 5°C higher than parts prepared similarly using conventional resins. More preferably the Tg is increased by at least 10°C. For instance, the glass-transition temperature of cured resin made from brominated bisphenol A epoxy resin and dicyanodiamide is preferably at least 140°C and more preferably at least about 144°C, as measured by differential scanning calorimetry (DSC). The parts prepared using the composition of this invention, demonstrate a higher solvent resistance, for example, demonstrate a pick-up of less than 1.0 percent N-methyl pyrrolidone. It is theorized, without intending to be bound, that these differences result from higher crosslink density, due to the higher catalyst loading.

Furthermore such parts exhibit a higher thermal performance as there is little or no solvent entrapped. The formulations of this invention preferably exhibit longer gel times at certain temperatures as compared to prior art formulations.

The following examples are presented to illustrate the invention. Unless otherwise stated all parts and percentages are by weight.

### Testing Methods

The following test methods are used unless stated otherwise in the examples. Unless stated otherwise, all parts and percentages are by weight.

### Stroke-Cure Gel Time

The test for stroke-cure gel time is available from The Dow Chemical Company as DOWM101210-TE92A (effective 26 May 1992). The published test is modified by changing the hardener/catalyst solution in paragraph (1) to reflect the actual composition to be tested. The test is summarized as follows:
(1) A hardener/catalyst solution is made by blending one or more solvents, a curing agent and a catalyst to reflect the curable composition to be tested. The materials are blended until all the dicyandiamide is dissolved. The blend should not be stored for more than one month. (Hardener/catalyst solutions in the present application ordinarily contain 173.00 g dimethylformamide, 173.00 g propylene glycol monomethyl ether, 28.00 g dicyandiamide and a desired quantity of 2-methylimidazole - all available from Aldrich Chemical Company. However, the tester should modify the solution to reflect the actual curable composition that is being tested.)
(2) The bottom side of a Model C01-T thermocouple (or equivalent) is pasted to a hot plate using a small amount of OMEGATHERM™ 201 thermally conductive paste, or equivalent. The thermocouple is attached to a Model 450-ATT thermocouple thermometer (or equivalent). The hot plate control is adjusted until a stable temperature of 171°C ± 0.5 is obtained. The hot plate should be located in a constant temperature area away from drafts to prevent temperature variations.
(3) A solution that contains 40 g of resin solids is added to a 4 oz. bottle, and 15.00 g of hardener/catalyst solution is added. Inhibitor may be added to the resin, before or immediately after the hardener/catalyst solution is added. The solutions are immediately blended and are left for one hour (from the time the hardener/catalyst solution was added) before beginning the test.
(4) A 0.5 to 0.7 mL sample of varnish is applied to the hot plate, and a timer is started. The sample rests undisturbed on the hot plate for 60 seconds ± 1. Then the sample is stroked with a wooden spatula by pushing the resin puddle back and forth over an area of about 6.45 cm² (1 in²) with the same side of the spatula in contact with the resin. The resin will thicken as it is stroked. Eventually, it becomes stringy, and then becomes a rubbery gel. That is the endpoint. The timer is stopped and the time is recorded. The resin is scraped from the plate using a razor blade being careful not to scratch the plate surface.
(5) The test is repeated three times, and the average time to form a gel is recorded.

### Curing

A sample is considered cured when its glass-transition temperature does not change by more than 3°C when the sample is tested twice by differential scanning calorimetry. The glass-transition temperature method is modified from the test published by The Institute for Interconnecting and Packaging Electronic Circuits in the IPC Test Methods Manual as test 2.4.25 (revision B, dated 12/87):
(1) A resin sample obtained from the stroke-cure gel time test is baked in a 175°C oven for the desired period of time.
(2) A specimen is cut from the sample and mounted in a standard aluminum sample pan. (The sample should not be higher than the edge of the pan). The sample is not a laminate, and so references to copper in the published test method can be ignored. An empty pan is used as a reference.
(3) The glass-transition temperature is measured using a DuPont Model 912 differential scanning calorimeter or equivalent, starting well below the point of interest and increasing temperature at a rate of 10°C/minute until 175°C is reached. The specimen is held at 175°C for 15 minutes (± 0.5) and then cooled over a period of 10 minutes to initial conditions.
(4) A second scan is carried out to a temperature of at least 180°C. The inflection points of the two scans are calculated by computer and taken to be the glass-transition temperatures of the sample. If the first and second scan are more than 3°C different, the sample is not cured.

### Examples

Example 1 - Trimethoxyboroxine Inhibitor

The following mixture was agitated for one hour:
- 100 parts -: 80 weight percent solids solution of brominated epoxy resin (prepared from tetrabromobisphenol A and diglycidyl ether of bisphenol A) dissolved in acetone;
- 4.5 parts -: 10 percent solution of 2-methylimidazole in dimethylformamide (DMF); and
- 27 parts -: 10 percent solution of dicyandiamide in a mixture of DMF and glycol ether; and
- 1.12 parts -: trimethoxyboroxine.
The gel time was tested as described previously. The gel time of the resin was about 249 seconds at about 171°C. The gelled resin was fully cured in no more than about 50 minutes at 175°C. After curing for 60 minutes, the glass-transition temperature of the resin was about 162°C.

### Example 2 - Trimethoxyboroxine inhibitor

The following varnish was agitated for several hours:
- 50 parts -: 80 weight percent solids solution of brominated epoxy resin (prepared from tetrabromobisphenol A and diglycidyl ether of bisphenol A) dissolved in acetone;
- 26.36 parts -: epoxy resin prepared from epichlorohydrin and bisphenol A;
- 14.01 parts -: tetrabromobisphenol A;
- 9.63 parts -: acetone
- 7.5 parts -: 10 percent solution of 2-methylimidazole in dimethylformamide (DMF); and
- 20 parts -: 10 percent solution of dicyandiamide in a mixture of DMF and glycol ether; and
- 0.87 parts -: trimethoxyboroxine.
The gel time was tested as described previously. The gel time of the varnish was about 226 seconds at about 171°C. The gelled varnish was fully cured in no more than about 50 minutes at 175°C.

A 0.15 meter (6 inch) by 0.15 meter (6 inch) prepreg of varnish and woven E-glass was cured according to the following conditions: Starting at a temperature of 121°C (250°F) and a pressure of 143 KPa. (20.8 psi), the temperature was increased to 177°C (350°F) at 2.8°C/minute (5°F/minute), and the pressure was increased to 3447 KPa (500 psi) at a rate of 143 KPa/minute (20.8 psi/minute). After curing for 60 minutes at 177°C (350°F) and 3447 KPa (500 psi), the laminate was cooled to 38°C (100°F) at 3447 KPa (500 psi) pressure. The glass-transition temperature of the prepreg was about 161°C.

### Example 3 - Zinc Chloride Inhibitor

The following mixture was agitated for one hour:
- 100 parts -: 80 weight percent solids solution of brominated epoxy resin (prepared from tetrabromobisphenol A and diglycidyl ether of bisphenol A) dissolved in acetone;
- 4.5 parts -: 10 percent solution of 2-methylimidazole in dimethylformamide (DMF); and
- 27 parts -: 10 percent solution of dicyandiamide in a mixture of DMF and glycol ether; and
- 4.4 parts -: 10 percent solution of zinc chloride in methanol.
The gel time was tested as described previously. The gel time of the resin was about 273 seconds at about 171°C. After curing for 60 minutes, the glass-transition temperature of the resin was about 144°C.

### Example 4 - Cure Time for Trimethylboroxine Inhibited System

A mixture of epoxy resin (80 percent solids in acetone), 0.45 phr of 2-methylimidazole (10 percent solids in DMF), 2.7 phr dicyandiamide (10 percent solids in DMF/glycol ether mixture) and 1.12 phr trimethoxyboroxine (18 percent solids in ethylene glycol) was cured at 175°C for the time shown in Table I. Two glass-transition temperatures are measured as described previously, and set out in Table I. The test shows that the resin was cured in no more than 45 minutes time.

**Table I**

| Cure Time (min) | Tg 1 (°C) | Tg 2 (°C) |
|---|---|---|
| 60 | 162 | 162 |
| 45 | 159 | 161 |
| 30 | 152 | 161 |

### Examples 5-16- Alternative Cure Inhibitors

The process of Example 1 was followed, substituting the inhibitors in Table II in the quantities in Table II for the trimethylboroxine shown in Example 1. Those results are shown in Table II. (A) is not an example of the invention.

**Table II**

| Ex | Inhibitor | Quantity (phr) | Gel Time (sec) |
|---|---|---|---|
| 5* | BCl₃ | 0.45 | 460 |
| 6 | TiCl₄ | 0.80 | 516 |
| 7 | TiCl₄ | 0.20 | 460 |
| 8 | TiCl₄ | 0.10 | 300 |
| 9 | SnCl₄ | 0.20 | 366 |
| 10 | CoCl₂ | 0.20 | 275 |
| 11 | CoCl₂ | 0.10 | 150 |
| 12 | CrCl₃ | 0.13 | 265 |
| 13 | MnCl₂ | 0.20 | 322 |
| 14 | FeCl₂ | 0.10 | 198 |
| 15 | FeCl₃ | 0.10 | 248 |
| 16 | SiCl₄ | 0.20 | 438 |
| A | None | 0 | 85 |

| | | | |
|---|---|---|---|
| * not an example according to the invention. | | | |

## Claims

1. An epoxy resin composition comprising
a) a polyepoxide;
b) an amine or amide curing agent for the polyepoxide;
c) a catalyst for the reaction of the polyepoxide with the curing agent; and
d) a cure inhibitor
characterized in that:
(1) the catalyst is an imidazole compound having a concentration of 0.3 to 1 part per 100 parts polyepoxide by weight (phr) and
(2) the cure inhibitor is a halide, oxide, hydroxide or alkoxide of zinc, tin, titanium, cobalt, manganese, iron, silicon or aluminum or a boron oxide or alkoxide.

2. A composition as described in Claim 1 which further comprises one or more solvents.

3. A composition as described in any of the previous Claims wherein the inhibitor is any of boroxine, boron oxide, an alkyl borate or a zinc halide.

4. A composition as described in any of the previous claims wherein the concentration of catalyst is at least 0.4 phr.

5. A composition as described in any of the previous Claims wherein the concentration of catalyst is no more than 0.5 phr.

6. A composition as described in any of the preceding Claims wherein the ratio of catalyst to inhibitor is 0.75:1 to 1.4:1.

7. Use of a composition as described in any of the previous claims to make a B-staged prepreg by the process of:
(1) impregnating a substrate with a curable composition as described in any of the previous Claims;
(2) drawing off solvent from the composition and partially curing the composition at a temperature of 80°C to 190°C to form a B-staged prepreg; and
(3) cooling tie B-staged prepreg and storing it at a temperature less than 50°C.

8. Use as described in Claim 7 which further comprises the step of:
(4) pressing one or more B-staged prepregs with one or more sheets of an electrically conductive material to form a laminate and curing the curable composition in the laminate.

9. A prepreg comprising:
(1) a fiber-containing substrate; and
(2) a partially-cured curable composition as described in any of Claims 1-7 adhered to the substrate.

10. A process for making a prepreg comprising the steps of:
(1). impregnating a substrate with a curable composition as defined in any of claims 1 to 6,
(2). drawing off solvent from the composition and partially curing the composition at a temperature of 80°C to 190°C to form a B-staged prepreg, and
(3). cooling the B-staged prepreg and storing it at a temperature less than 50°C.

## Patentansprüche

1. Epoxyharzzusammensetzung, umfassend:
a) ein Polyepoxid,
b) einen Amin- oder Amidhärter für das Polyepoxid,
c) einen Katalysator für die Reaktion des Polyepoxids mit dem Härter; und
d) einen Härtungsinhibitor,
dadurch gekennzeichnet, daß
(1) der Katalysator eine Imidazolverbindung ist, die eine Konzentration von 0,3 bis 1 Teil pro 100 Teile Polyepoxid in Gewicht (phr) hat, und
(2) der Härtungsinhibitor ein Halogenid, Oxid, Hydroxid oder Alkoxid von Zink, Zinn, Titan, Kobalt, Mangan, Eisen, Silizium oder Aluminium oder ein Boroxid oder -alkoxid ist.

2. Zusammensetzung nach Anspruch 1, welche weiter ein oder mehrere Lösungsmittel umfaßt.

3. Zusammensetzung nach einem der vorhergehenden Ansprüche, in welcher der Inhibitor ein beliebiger von Boroxin, Boroxid, ein Alkylborat oder ein Zinkhalogenid ist.

4. Zusammensetzung nach einem der vorhergehenden Ansprüche, in welcher die Konzentration von Katalysator wenigstens 0,4 phr ist.

5. Zusammensetzung nach einem der vorhergehenden Ansprüche, in welcher die Konzentration von Katalysator nicht mehr als 0,5 phr ist.

6. Zusammensetzung nach einem der vorhergehenden Ansprüche, in welcher das Verhältnis von Katalysator zu Inhibitor 0,75:1 bis 1,4:1 ist.

7. Verwendung einer Zusammensetzung wie in einem der vorhergehenden Ansprüche beschrieben zur Herstellung eines B-Stufen Prepregs nach dem Verfahren von:
(1) Imprägnieren eines Substrates mit einer härtbaren Zusammensetzung wie in einem der vorhergehenden Ansprüche beschrieben,
(2) Abziehen von Lösungsmittel aus der Zusammensetzung und partielles Härten der Zusammensetzung bei einer Temperatur von 80°C bis 190°C zur Bildung eines B-Stufen Prepregs, und
(3) Abkühlen des B-Stufen Prepregs und Lagern hiervon bei einer Temperatur von weniger als 50°C.

8. Verwendung nach Anspruch 7, welche weiter die Stufe umfaßt von:
(4) Pressen von einem oder mehreren B-Stufen Prepregs mit einem oder mehreren Folien eines elektrisch leitfähigen Materials zur Bildung eines Laminates und Aushärten der härtbaren Zusammensetzung in dem Laminat.

9. Prepreg, umfassend:
(1) ein faserhaltiges Substrat, und
(2) eine partiell gehärtete aushärtbare Zusammensetzung wie in einem der Ansprüche 1 - 7 beschrieben, anhaftend an dem Substrat.

10. Verfahren zur Herstellung eines Prepregs, umfassend die Stufen von:
(1) Imprägnieren eines Substrates mit einer härtbaren Zusammensetzung wie in einem der Ansprüche 1 - 6 beschrieben,
(2) Abziehen von Lösungsmittel aus der Zusammensetzung und partielles Härten der Zusammensetzung bei einer Temperatur von 80°C bis 190°C zur Bildung eines B-Stufen Prepregs, und
(3) Abkühlen des B-Stufen Prepregs und Lagern hiervon bei einer Temperatur von weniger als 50°C.

## Revendications

1. Composition de résine époxyde comprenant :
a) un polyépoxyde,
b) un agent de durcissement de type amide ou amine pour le polyépoxyde, et
c) un catalyseur pour la réaction du polyépoxyde avec l'agent de durcissement, et
d) un inhibiteur de durcissement ;
caractérisée en ce que :
(1) le catalyseur est un composé de type imidazole présentant une concentration de 0,3 à 1 partie pour 100 parties de polyépoxyde en poids (pcr) et
(2) l'inhibiteur du durcissement est un halogénure, oxyde, hydroxyde ou alcoxyde de zinc, d'étain, de titane, de cobalt, de manganèse, de fer, de silicium ou d'aluminium, ou un oxyde ou alcoxyde de bore.

2. Composition selon la revendication 1, qui comprend en outre un ou plusieurs solvants.

3. Composition selon l'une quelconque des précédentes revendications, dans laquelle l'inhibiteur est l'un quelconque des boroxine, oxyde de bore, borate d'alkyle ou halogénure de zinc.

4. Composition selon l'une quelconque des précédentes revendications, dans laquelle la concentration du catalyseur vaut au moins 0,4 pcr.

5. Composition selon l'une quelconque des revendications, dans laquelle la concentration du catalyseur ne dépasse pas 0,5 pcr.

6. Composition selon l'une quelconque des précédentes revendications, dans laquelle le rapport du catalyseur à l'inhibiteur va de 0,75:1 à 1,4:1.

7. Utilisation d'une composition selon l'une quelconque des précédentes revendications, pour fabriquer un préimprégné prépolymérisé par le procédé consistant à :
(1) imprégner un substrat avec une composition durcissable telle que définie dans l'une quelconque des précédentes revendications ;
(2) soutirer le solvant de la composition et à faire durcir partiellement la composition à une température de 80 °C à 190 °C pour former un préimprégné prépolymérisé ; et à
(3) refroidir le préimprégné prépolymérisé et à le stocker à une température inférieure à 50 °C.

8. Utilisation selon la revendication 7, qui comprend en outre l'étape consistant à :
(4) presser un ou plusieurs préimprégnés prépolymérisés avec une ou plusieurs feuilles d'un matériau conducteur électrique pour former un stratifié et à faire durcir la composition durcissable dans le stratifié.

9. Préimprégné comprenant :
(1) un substrat fibreux ; et
(2) une composition durcissable partiellement durcie selon l'une quelconque des revendications 1 à 6, adhérant au substrat.

10. Procédé pour fabriquer un préimprégné, comprenant les étapes consistant à :
(1) imprégner un substrat avec une composition durcissable telle que définie dans l'une quelconque des revendications 1 à 7 ;
(2) soutirer le solvant de la composition et à faire durcir partiellement la composition à une température de 80 °C à 190 °C pour former un préimprégné prépolymérisé ; et
(3) refroidir le préimprégné prépolymérisé et à le stocker à une température inférieure à 50 °C.
